# EUROPÄISCHE PATENTANMELDUNG

(11) **EP 2 458 393 A2**
(43) Veröffentlichungstag der Anmeldung: **30.05.2012**
(21) Anmeldenummer: 11005820.3
(22) Anmeldetag: 15.07.2011
(51) Int. Cl.: G01R 31/00, H01L 31/18, H01L 31/076

(54) **Verfahren zur Bestimmung der Kenngrössen einer photovoltaischen Einrichtung**

(30) Priorität: 31.08.2010 DE 102010035961; 13.01.2011 DE 102011008450
(71) Anmelder: SCHOTT Solar AG, 55122 Mainz (DE)
(72) Erfinder: Haslauer, Andreas, 81278 Puchheim (DE); Lechner, Peter, 85540 Haar (DE)
(74) Vertreter: von Puttkamer · Berngruber

(57) **Zusammenfassung**

Zur Bestimmung der Kenngrößen einer zu prüfenden photovoltaischen Einrichtung, welche wenigstens eine Mehrfachsolarzelle aufweist, die aus wenigstens zwei übereinander geschichteten, elektrisch und optisch in Serie geschalteten Teilzellen (1, 2) besteht, die jeweils eine p-leitende Schicht (p1, p2), eine intrinsische Schicht (i1, i2) und eine n-leitende Schicht (n1, n2) aufweisen, wird für jede Teilzelle (1, 2) wenigstens eine Referenzzelle (Rb, Rt) hergestellt. Die eine Teilzelle (2, 1) jeder Referenzzelle (Rb, Rt) entspricht einer Teilzelle (2, 1) der wenigstens zwei Teilzellen (1, 2) der Mehrfachsolarzelle. Demgegenüber weist die wenigstens eine weitere Teilzelle (1, 2) jeder Referenzzelle (Rb, Rt) wenigstens eine Schicht (11, 12) auf, welche der intrinsischen Schicht (i1, i2) der wenigstens einen weiteren Teilzelle (1, 2) der Mehrfachsolarzelle entspricht, jedoch durch Dotierung in eine elektrisch leitfähige Schicht (11, 12) umgewandelt ist. Es wird die spektrale Empfindlichkeit der Referenzzellen (Rb, Rt) gemessen. Zur Bestimmung der Kenngrößen der Mehrfachsolarzelle werden die Kenngrößen der Referenzzellen (Rb, Rt) und die Kenngrößen der Mehrfachsolarzelle mit einem auf die Referenzzellen (Rb, Rt) kalibrierten Sonnensimulator unter den gleichen Bedingungen gemessen.

## Beschreibung

Die Erfindung bezieht sich auf ein Verfahren zur Bestimmung der Kenngrößen einer photovoltaischen Einrichtung mit wenigstens einer Mehrfachsolarzelle. Sie hat auch eine Referenzzelle bzw. ein photovoltaisches Referenzmodul zur Durchführung des Verfahrens zum Gegenstand.

Dünnschichtsolarzellen weisen im Allgemeinen die Schichtfolge p-i-n, d. h. eine p-leitende oder p-Schicht, eine intrinsische oder i-Schicht und eine n-leitende oder n-Schicht auf, wobei über die gesamte i-Schicht ein elektrisches Feld erzeugt wird.

Bei Mehrfachsolarzellen, die aus zwei, drei oder mehr übereinander geschichteten, elektrisch und optisch in Serie geschalteten Teilzellen mit der Schichtfolge p-i-n bestehen, können die jeweiligen i-Schichten aus Materialien mit gleichen oder unterschiedlichen Bandlücken aufgebaut sein. Durch Optimierung auf einen bestimmten Wellenlängenbereich wird damit der Wirkungsgrad erhöht.

Im Rahmen der Entwicklung und zur Produktionskontrolle von Solarzellen werden für die Hellkennlinienmessung der Zelleffizienz oder Modulleistung unter Standard-Testbedingungen (englisch: Standard Test Conditions STC) jeweils Sonnensimulatoren, beispielsweise Xenon-Blitzlampen verwendet.

Vorzugsweise wird ein Sonnensimulator verwendet, der ein Strahlungsspektrum aufweist, das mit dem Referenzsonnenspektrum übereinstimmt. Doch sind selbst bei der höchsten Genauigkeitsklasse A nach IEC 60904-9 des Sonnensimulators spektrale Abweichungen bis 25 % in definierten Wellenlängenbereichen zulässig.

Mittels kalibrierter Referenzzellen können die Spektralbereiche des Sonnensimulatorlichts vermessen und damit beispielsweise die Solarzellenproduktion überwacht werden.

Für Dünnschichtsolarzellen und -module werden als Referenzzellen häufig mit Farbglas gefilterte kristalline Solarzellen verwendet. Der Farbglasfilter hat die Aufgabe, die spektrale Empfindlichkeit oder Quanteneffizienz der Referenzzelle möglichst an die Quanteneffizienz der zu prüfenden Solarzelle bzw. des zu prüfenden Moduls anzupassen. Da die Auswahl an geeigneten Farbglasfiltern beschränkt ist, gelingt eine Anpassung der spektralen Empfindlichkeit der Referenzzelle an die des Prüflings jedoch nur unvollständig. Dadurch entsteht eine spektrale Fehlanpassung zwischen Prüfling und Referenzzelle, die eine aufwändige Korrektur der Kenngrößen des Prüflings mit Hilfe eines spektralen Fehlanpassungsfaktors (englisch: Miss Match Factor MMF) erfordert. Hierfür wird die spektrale Verteilung der solaren Referenzbestrahlungsstärke, wie z. B. in IEC 60904-3 angegeben, die spektrale Bestrahlungsstärkenverteilung des einfallenden Licht bei der Messung sowie die spektrale Empfindlichkeit der Referenzzelle und des Prüflings benötigt.

Damit ist es möglich, wenn auch mit erheblichem Aufwand, die Kenngrößen, insbesondere die Leistung einer Einfachsolarzelle (Single-Junction-Einrichtung) mit einer hinreichenden Genauigkeit zu prüfen.

Die elektrische Vermessung einer Mehrfachsolarzelle (Multi-Junction-Einrichtung) ist jedoch wesentlich schwieriger als die einer Einfachsolarzelle, da ein elektrischer Zugriff auf die Teilzellen nicht möglich ist, man also nur immer die Mehrfachzelle über zwei Anschlüsse als eine elektrische und optische Einheit messen kann.

Zwar ist in DIN EN 60904-7 angegeben, dass die Gleichung für den spektralen Fehlanpassungsfaktor auch auf Mehrfachsolarzellen angewendet werden kann. Tatsächlich ist eine solche Fehlanpassung bei Mehrfachsolarzellen praktisch aber unmöglich. Bei der Kalibrierung von Mehrfachsolarzellen müssen nämlich dann als Sonnensimulatoren Mehrfach-Lichtquellen verwendet werden, um der spektralen Fehlanpassung zwischen der Referenzzelle und der jeweiligen Teilzelle der Mehrfachzelle Rechnung zu tragen. Dieser Kalibriervorgang stellt einen langwierigen, iterativen Prozess dar, da sich während der Einstellung der Bestrahlungsintensität einer Teil-Lichtquelle die spektrale Summen-Verteilung verändert und somit im allgemeinen eine Neuberechnung des MMF notwendig wird.

Alternativ ist die etwas weniger aufwändige Lösung eines linearen Gleichungssystems mit n-Gleichungen - für n voneinander unabhängige Teil-Lichtquellen - möglich. Jedoch wird hier vorausgesetzt, dass sich die spektrale Verteilung einer Teil-Lichtquelle bei Änderung der Intensität nicht verändert, was nur bei kleinen Änderungen in erster Näherung zulässig ist. Ein weiterer Nachteil sind die mit wenigen Quadratzentimeter geringen Abmessungen der gefilterten Referenzsolarzellen. Großflächige Sonnensimulatoren lassen sich aufgrund örtlicher Spektral- und Intensitäts-Inhomogenitäten nur unter erheblichem Mess- und Zeitaufwand mit diesen kleinflächigen Referenzzellen kalibrieren. Dieser Aufwand ist insbesondere in der Produktion von photovoltaischen Dünnschichtmodulen unerwünscht.

Aufgabe der Erfindung ist es daher, ein Verfahren sowie eine Referenzzelle und ein Referenzmodul bereitzustellen, um die Kenngrößen von Mehrfachsolarzellen und photovoltaischen Modulen mit Mehrfachsolarzellen, insbesondere deren Leistung exakt zu bestimmen.

Dies wird erfindungsgemäß mit dem im Anspruch 1 angegebenen Verfahren erreicht. In den Ansprüchen 2 bis 8 sind vorteilhafte Ausgestaltungen des erfindungsgemäßen Verfahrens wiedergegeben. In den Ansprüchen 9 bis 11 ist eine Referenzzelle und in den Ansprüchen 12 und 13 ein Referenzmodul zur Durchführung des erfindungsgemäßen Verfahrens gekennzeichnet.

Nach der Erfindung wird zur Bestimmung der Kenngrößen einer photovoltaischen Einrichtung mit wenigstens einer Mehrfachsolarzelle, die aus wenigstens zwei übereinander geschichteten elektrisch und optisch in Serie geschalteten Teilzellen besteht, die jeweils eine p-Schicht, eine i-Schicht und eine n-Schicht aufweisen, für jede Teilzelle der Mehrfachsolarzelle eine Referenzzelle hergestellt. Jede Referenzzelle umfasst die gleiche Anzahl von Teilzellen wie die Mehrfachsolarzelle, also wenigstens zwei Teilzellen.

Eine Teilzelle der wenigstens zwei Teilzellen jeder Referenzzelle entspricht einer Teilzelle der wenigstens zwei Teilzellen der Mehrfachsolarzelle, und zwar insbesondere bezüglich der Lage in der Referenzzelle, der Materialien und der Schichtdicke sowie vorzugsweise auch der Dotierung, optischen Bandlücke, dem Grading der Bandlücke, der Kristallinität, insbesondere Ramankristallinität, Defektdichte und Pufferschichten.

Das heißt, die eine Teilzelle der wenigstens zwei Teilzellen jeder Referenzzelle weist dieselbe Lage in den übereinander geschichteten Teilzellen der Referenzzelle auf wie die eine Teilzelle der wenigstens zwei Teilzellen der Mehrfachsolarzelle.

Bei einer Zweifach- oder Tandemzelle als Mehrfachsolarzelle werden also zwei Referenzzellen hergestellt, wobei in der einen Referenzzelle die bottom-Zelle der bottom-Zelle der Tandemzelle entspricht, und in der anderen Referenzzelle die top-Zelle der top-Zelle der Tandemzelle.

Darüber hinaus besteht die eine Teilzelle der wenigstens zwei Teilzellen jeder Referenzzelle aus denselben Materialien wie die eine Teilzelle der wenigstens zwei Teilzellen der Mehrfachsolarzelle, also aus demselben Halbleitermaterial und denselben Dotierstoffen, einschließlich Dotierstoffkonzentration.

Auch sind die Schichtdicken der einen Teilzelle der wenigstens zwei Teilzellen jeder Referenzzelle, also die Schichtdicke der p-Schicht, der i-Schicht und der n-Schicht dieselben wie in der einen Teilzelle der Mehrfachsolarzelle.

Zudem sind vorzugsweise auch alle übrigen Eigenschaften, insbesondere die optische Bandlücke, das Grading der Bandlücke, die Kristallinität, insbesondere Ramankristallinität, die Defektdichte und Pufferschichten der einen Teilzelle der wenigstens zwei Teilzellen der Referenzzelle dieselben wie die der einen Teilzelle der wenigstens zwei Teilzellen der Mehrfachzelle.

D. h. bei einer Tandemzelle als Mehrfachsolarzelle werden zwei Referenzzellen hergestellt, wobei die eine Referenzzelle eine bottom-Zelle und die andere Referenzzelle eine top-Zelle aufweist, die insbesondere aus denselben Materialien besteht und dieselbe Schichtdicke aufweist wie die bottom-Zelle bzw. top-Zelle der Tandemzelle, wobei vorzugsweise die optische Bandlücke, das Grading der Bandlücke, die Kristallinität, insbesondere Ramankristallinität der bottom-Zelle der einen Referenzzelle und der top-Zelle der anderen Referenzzelle mit der bottom-Zelle bzw. top-Zelle der Tandemzelle ebenfalls identisch übereinstimmen.

Demgegenüber weist die wenigstens eine weitere Teilzelle jeder Referenzzelle wenigstens eine Schicht auf, welche der i-Schicht der wenigstens einen weiteren Teilzelle der Mehrfachsolarzelle entspricht, jedoch durch Dotierung in eine elektrisch leitfähige Schicht umgewandelt ist.

Die weitere oder im Fall einer Mehrfachsolarzelle mit mehr als zwei Teilzellen jede weitere Teilzelle der Referenzzelle, die durch Dotierung in eine elektrisch leitfähige Schicht umgewandelt ist, ist damit photovoltaisch inaktiv.

Das heißt, erfindungsgemäß wird für jede Teilzelle der Mehrfachsolarzelle eine Referenzzelle hergestellt, bei der die intrinsische Schicht der wenigstens einen weiteren Teilzelle der Mehrfachsolarzelle durch Dotierung in eine elektrisch leitfähige Schicht umgewandelt ist, wobei die p-leitende Schicht oder die n-leitende Schicht oder die p- und die n-leitenden Schicht der wenigstens einen weiteren Teilzelle der Referenzzelle nicht ausgeführt sein kann.

Damit umfasst jede Referenzzelle eine erste Teilzelle mit einer pin-Struktur und wenigstens eine photovoltaisch inaktive Teilzelle, die eine elektrisch leitfähige Schicht aufweist, jedoch aus demselben Halbleitermaterial besteht und die gleiche Schichtdicke besitzt wie die wenigstens eine weitere Teilzelle der Mehrfachsolarzelle.

Vorzugsweise weist jedoch die wenigstens eine weitere Teilzelle der Referenzzelle die durch Dotierung der i-Schicht in eine elektrisch leitfähige Schicht umgewandelte Schicht sowie die p-leitende Schicht und/oder n-leitende Schicht der wenigstens einen weiteren Teilzelle der Mehrfachsolarzelle auf, wobei insbesondere Referenzzellen, bei denen die weitere Teilzelle aus der durch Dotierung der i-Schicht in eine elektrisch leitfähige Schicht umgewandelten Schicht und der p-leitenden Schicht sowie der n-leitenden Schicht der wenigstens einen weiteren Teilzelle der Mehrfachsolarzelle gebildet ist, eine besonders exakte Bestimmung der Kenngrößen der Mehrfachsolarzelle, insbesondere deren Leistung ermöglicht.

Das heißt, bei einer Zweifach- oder Tandemsolarzelle wird damit vorzugsweise für die beiden Teilzellen jeweils eine Referenzzelle hergestellt, in dem die intrinsische Schicht der anderen Teilzelle durch Dotierung in eine elektrisch leitfähige Schicht umgewandelt wird, während bei einer Mehrfachsolarzelle mit mehr als zwei Teilschichten für jede Teilzelle eine Referenzzelle hergestellt wird, wobei die intrinsische Schicht der übrigen Teilzellen der Mehrfachsolarzelle dotiert, also in eine elektrisch leitfähige Schicht umgewandelt ist.

Die Quanteneffizienz oder spektrale Empfindlichkeit der so hergestellten Referenzzellen wird mit einem Sonnensimulator gemessen. Ferner werden die Kenngrößen der Referenzzellen und die Kenngrößen der Mehrfachsolarzelle mit dem Sonnensimulator unter den gleichen Bedingungen gemessen. Durch Vergleich der Kenngrößen der Mehrfachsolarzelle mit den Kenngrößen der Referenzzellen kann damit insbesondere die Leistung der Mehrfachsolarzelle bestimmt werden.

Erfindungsgemäß wird dadurch die spektrale Empfindlichkeit der Referenzzelle für eine Teilzelle an die spektrale Empfindlichkeit dieser Teilzelle in der Mehrfachsolarzelle im Wesentlichen identisch angepasst.

Das erfindungsgemäße Verfahren ist insbesondere zur Bestimmung der Kenngrößen einer Siliziumdünnschicht-Mehrfachsolarzelle geeignet.

Dabei kann die p- und/oder n-Schicht wenigstens einer Teilzelle der Siliziumdünnschicht-Mehrfachsolarzelle durch Kohlenstoff, Sauerstoff und/oder Stickstoff legiert sein, um die Bandlücke zur vergrößern. Zur Dotierung der p-Schicht der Teilzellen kann beispielsweise Bor verwendet werden, zu der der n-Schicht Phosphor.

Zur Herstellung der Mehrfachzellen wird vorzugsweise die chemische Dampfabscheidung (Chemical Vapor Deposition, CVD) verwendet, insbesondere das plasmaunterstützte (plasma enhanced) PECVD-Verfahren.

Die Schichten der einzelnen Teilzellen werden durch das Zerlegen von Silizium enthaltenden Gasen in dem Plasma hergestellt. Als Depositionsgas dient meist Silan oder Disilan. Neben den (undotierten) i-Schichten werden die dotierten p- und n-Schichten abgeschieden, und zwar die p-Schichten, durch die das Licht in die i-Schicht der jeweiligen Teilzelle fällt, üblicherweise durch Beimengung von Diboran oder Trimethylbor zum Depositionsgas und die n-Schichten durch Beimengung von Phosphin zum Depositionsgas. Die i-Schicht der Teilzellen kann aus einem Siliziummaterial mit der gleichen Bandlücke bestehen, beispielsweise ausschließlich aus amorphem Silizium oder aus Siliziummaterialien mit unterschiedlichen Bandlücken, beispielsweise aus amorphem Silizium in einer oder mehreren Teilzellen und mikrokristallinem Silizium in der oder den übrigen Teilzellen oder amorphem Silizium in einer oder mehreren Teilzellen und amorphem Siliziumgermanium (Si-Ge-Legierung) in der oder den übrigen Teilzellen der Mehrfachsolarzelle.

So wird bei einer Tandemsolarzelle erfindungsgemäß die optische Empfindlichkeit oder Quanteneffizienz der bottom- oder top-Zelle als Einfachzelle nahezu perfekt nachgebildet, die dann als Referenzzelle bzw. als großflächiges Referenzmodul verwendet wird. Die Quanteneffizienz einer solchen Teilzelle innerhalb einer Tandemzelle ist ein komplexes Ergebnis optischer Wechselwirkung in einem Dünnschichtsystem auf nicht glatten Oberflächen von mehr als zehn Einzelschichten mit Schichtdicken zwischen etwa 5 und 3000 nm. Eine Nachbildung der Quanteneffizienz mit optischen Filtern wie nach dem Stand der Technik, ist deshalb ein aussichtsloses Unterfangen.

Dabei wird erfindungsgemäß die intrinsische und daher normalerweise undotierte Schicht der übrigen Teilzellen der Mehrfachsolarzelle, bei dem erwähnten Beispiel der Tandemsolarzelle, also die intrinsische, normalerweise undotierte Schicht der top-Zelle so hoch n- oder p-dotiert, dass diese eine Dunkelleitfähigkeit von mindestens 10E-5 S/cm, insbesondere von mindestens 10E-4 S/cm aufweist. Gleiches gilt für die i-Schicht der bottom-Zelle.

Das erfindungsgemäße Verfahren ist insbesondere zur Ermittlung der Leistung einer Mehrfachsolarzelle und eines photovoltaischen Moduls bestimmt. Als Standard-Testbedingungen (STC) wird dabei eine Einstrahlungsstärke des Sonnensimulators von beispielsweise 1000 W/m² in die Ebene der Mehrfachsolarzelle bzw. in die Modulebene, eine Temperatur der Solarzelle beispielsweise von konstant 25° und z. B. ein AM 1.5 G-Spektrum, also das globale Sonnenstrahlungsspektrum bei einem Einfallswinkel von 48° gegenüber der Senkrechten angewendet.

Die Leistung ergibt sich aus dem Produkt aus Stromstärke und der Spannung am maximalen Arbeitspunkt bei Hellkennlinienmessung, also der Messung mit dem Sonnensimulator.

Bei einer Tandemsolarzelle werden also erfindungsgemäß zwei Referenzzellen hergestellt, die die gleiche Schichtfolge wie die Tandemsolarzelle aufweisen, bei denen jedoch die i-Schicht der top-Zelle bzw. der bottom-Zelle durch Dotieren in eine elektrisch leitende Schicht umgewandelt ist, um die Referenzzelle für die bottom-Zelle bzw. die top-Zelle zu bilden.

Anschließend wird die spektrale Empfindlichkeit der beiden Referenzzellen und damit der bottom- und der top-Zelle ermittelt, die mit der spektralen Empfindlichkeit der bottom- und der top-Zelle der Tandemsolarzelle, deren Leistung bestimmt werden soll, übereinstimmt.

Die Leistung der beiden Referenzzellen bei dem Sonnenreferenzspektrum, beispielsweise AM1.5G kann aufgrund der ermittelten spektralen Empfindlichkeit gemessen oder rechnerisch bestimmt werden. Typischerweise erfolgt dieser Kalibriervorgang bei einem Metrologieinstitut wie der Physikalisch-Technischen Bundesanstalt (PTB) oder bei einem akkreditierten Prüflabor wie dem Fraunhofer Institut für Solare Energie (ISE).

Zur Bestimmung der Kenngrößen und damit der Leistung der zu prüfenden Tandemsolarzelle wird ein spektral einstellbarer Sonnensimulator verwendet, der ein Strahlungsspektrum aufweist, das mit dem Referenzsonnenspektrum nicht übereinzustimmen braucht. Allein, das Strahlungsspektrum des Sonnensimulators wird so eingestellt, dass bei einer Tandemzelle die Leistung der beiden Referenzzellen der bei der Kalibrierung bestimmten Leistung entspricht.

Dazu kann mit dem Sonnensimulator ein Mischlicht aus zwei oder mehr Lichtquellen mit unterschiedlichen Strahlungsfrequenzspektren erzeugt werden, das gegebenenfalls durch Filter zusätzlich modifiziert werden kann. Der Sonnensimulator zur Bildung des Mischlichts kann z. B. Xenonlampen, Halogenmetalldampflampen oder dergleichen mit unterschiedlichem Strahlungsspektrum aufweisen und z. B. ein Blitzlicht-Simulator sein.

Damit kann der so eingestellte Sonnensimulator erhebliche Abweichungen vom solaren Referenzspektrum aufweisen, der Sonnensimulator kann also durchaus einer spektralen Genauigkeitsklasse B oder C oder auch schlechter entsprechen. Auch muss bei der erfindungsgemäßen Methode das Bestrahlungsspektrum des Sonnensimulators nicht gemessen werden.

Somit entspricht die Leistung der beiden Referenzzellen für die top-Zelle bzw. die bottom-Zelle, z. B. einer Tandemsolarzelle, der Leistung der Tandemsolarzelle in dem Referenzsonnenspektrum, z. B. AM1.5G.

Durch den Abstand des Sonnensimulators und/oder dessen Leistung kann die Bestrahlungsstärke z. B. auf 1000 W/m² eingestellt werden. Die Leistung der zu prüfenden Tandemsolarzelle wird mit dem Sonnensimulator unter den gleichen Bedingungen gemessen.

Auf diese Weise kann eine Abweichung der Leistung der zu prüfenden Tandem- oder Mehrfachsolarzelle von der Gesamtleistung der Referenzzellen mit einer hohen Genauigkeit von 5 % und deutlich weniger festgestellt werden.

Mit der gleichen hohen Genauigkeit kann erfindungsgemäß die Leistung eines photovoltaischen Moduls gemessen werden, das eine Vielzahl serienverschalteter Einzelzellen aufweist und gegebenenfalls mit Kontaktbändchen, Kabel, Rückseitenverkapselung und dergleichen ein gebrauchsfertiges Modul bildet.

Dazu wird für jede Teilzelle der Mehrfachsolarzellen, aus denen die serienverschalteten Einzelzellen des Moduls bestehen, ein Referenzmodul hergestellt. Die einzelnen Referenzmodule unterscheiden sich dann dadurch voneinander, dass jeweils eine andere Teilzelle der Mehrfachsolarzellen des Moduls die p-i-n-Schichtfolge aufweist, während bei den übrigen Teilzellen der Mehrfachsolarzellen des Moduls die i-Schicht durch Dotierung in eine elektrisch leitende Schicht umgewandelt und damit kurzgeschlossen ist.

Das erfindungsgemäße Verfahren ist damit auch für großflächige bauartgleiche Module in jedweder Größe und Design geeignet.

Es lässt sich auch vortrefflich als Evaluierung und Monitoring zur Prozesskontrolle im Rahmen einer Prozessentwicklung bzw. innerhalb der Modulproduktion einsetzen.

Nachstehend ist die Erfindung anhand der beigefügten Zeichnung beispielhaft näher erläutert. Darin zeigen:
Figur 1 bis 3 schematisch den Aufbau einer Tandemsolarzelle bzw. einer Referenzzelle für die bottom-Zelle bzw. top-Zelle der Tandemsolarzelle;
Figur 4 die spektrale Empfindlichkeit der bottom-Zelle der Referenzzelle nach Figur 2 und der bottom-Zelle sowie der top-Zelle der zu prüfenden Tandem-Solarzelle; und
Figur 5 die IV-Kennlinien und tabellarisch gelisteten Kennwerte von erfindungsgemäßen Referenzzellen für die bottom-Zelle.

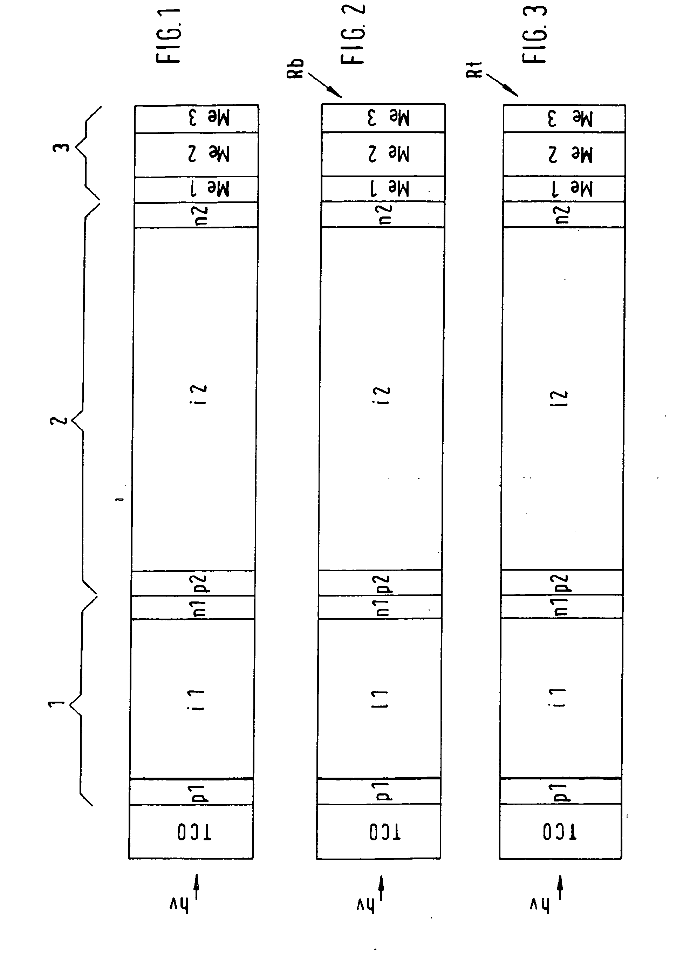

Gemäß Figur 1 weist die Tandemsolarzelle eine transparente elektrisch leitfähige Frontelektrodenschicht TCO, eine erste Teilzelle oder top-Zelle 1, auf die das Licht fällt, eine zweite Teilzelle oder bottom-Zelle 2 und eine Rückelektroden- und Reflektorschicht 3 auf.

Die top-Zelle 1 und die bottom-Zelle 2 sind jeweils als p-i-n-Zelle ausgebildet, d. h. sie weisen an ihrer vorderen, also Lichteinfallsseite, jeweils eine p-Schicht p1, p2 und an ihrer rückwärtigen Seite jeweils eine n-Schicht n1, n2 auf. Zwischen den p-Schichten p1, p2 und den n-Schichten n1, n2 jeder Teilzelle 1, 2 ist jeweils ein intrinsische oder i-Schicht i1, i2 vorgesehen.

Die p-Schichten p1, p2 und die n-Schichten n1, n2 bestehen jeweils aus amorphem Silizium, ebenso die i-Schicht i1 der top-Zelle 1. Die i-Schicht i2 der bottom-Zelle 2 besteht z. B. aus mikrokristallinem Silizium. Die Rückelektroden- und Reflektorschicht 3 ist aus mehreren aufeinander geschichteten Metallschichten Me1, Me2 und Me3 zusammengesetzt, z. B. Cu (Me1), Ag (Me2) und NiV (Me3).

Nach Figur 2 weist die Referenzzelle Rb zur Bestimmung der Kenngrößen der bottom-Zelle 2 der Tandemsolarzelle nach Figur 1 die gleiche Schichtfolge wie die Tandemsolarzelle nach Figur 1 auf, mit dem Unterschied, dass die i-Schicht i1 der top-Zelle 1 durch Dotieren in eine elektrisch leitfähige Schicht 11 umgewandelt, also kurz geschlossen worden ist.

Nach Figur 3 weist die Referenzzelle Rt zur Bestimmung der Kenngrößen der top-Zelle 1 der Tandemsolarzellen nach Figur 1 ebenfalls die gleiche Schichtfolge wie die Tandemsolarzelle nach Figur 1 auf, wobei jedoch die i-Schicht i2 der bottom-Zelle 2 durch Dotieren in eine elektrisch leitfähige Schicht 12 umgewandelt und damit kurz geschlossen worden ist.

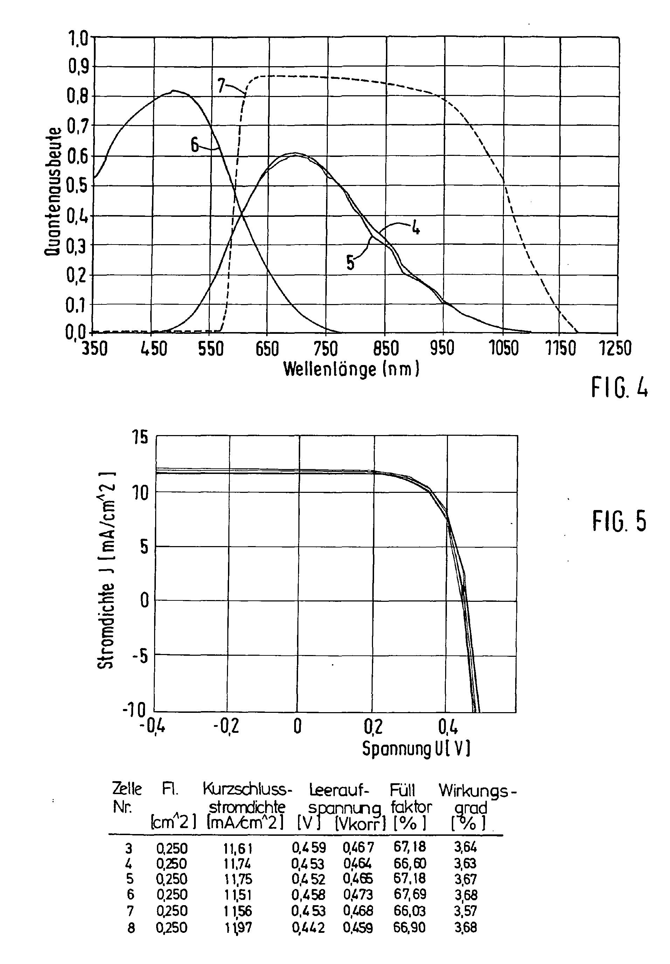

In Figur 4 zeigt die Kurve 4 die spektrale Empfindlichkeit oder Quanteneffizienz der bottom-Zelle 2 der Tandemsolarzelle nach Figur 1, und die Kurve 5 die spektrale Empfindlichkeit oder Quanteneffizienz der bottom-Zelle 2 der Referenzzelle Rb nach Figur 2, welche die gleiche i-Schicht i2 aufweist, wie die Tandemsolarzelle nach Figur 1.

Es ist ersichtlich, dass die spektrale Empfindlichkeit der bottom-Zelle 2 der Tandemsolarzelle nach Figur 1 mit der spektralen Empfindlichkeit der bottom-Zelle 2 der Referenzzelle Rb nahezu identisch übereinstimmt.

Das heißt, wenn die Kenngrößen einer zu prüfenden Tandemsolarzelle, die entsprechend Figur 1 aufgebaut ist, und die Kenngrößen der Referenzzellen Rb und Rt mit einem auf die Referenzzellen Rb und Rt kalibrierten Sonnensimulator unter den gleichen Bedingungen gemessen werden, können die Kenngrößen der zu prüfenden Tandemsolarzelle mit hoher Genauigkeit ohne Anwendung eines spektralen Fehlanpassungsfaktors bestimmt werden, und damit insbesondere die Leistung der Tandemsolarzelle.

Gleiches gilt für die spektrale Empfindlichkeit der top-Zelle 1 der zu prüfenden Tandemsolarzelle gegenüber der Referenzzelle Rt, wobei in Figur 4 die Kurve 6 die spektrale Empfindlichkeit der top-Zelle 1 der Tandemsolarzelle nach Figur 1 dargestellt ist.

In Figur 4 stellt die gestrichelte Kurve 7 dazu zum Vergleich die spektrale Empfindlichkeit einer mit Farbglas gefilterten Referenzzelle dar, wie sie nach dem Stand der Technik eingesetzt wird.

Nach Figur 2 und 3 weisen die Referenzzellen Rb und Rt jeweils eine top-Zelle 1 bzw. eine bottom-Zelle 2 auf, bei der die intrinsische Schicht der top-Zelle 1 bzw. der bottom-Zelle 2 durch Dotierung in eine elektrisch leitfähige, photovoltaisch inaktive Schicht 11 bzw. 12 umgewandelt worden ist, jedoch dieselbe p-leitende Schicht p1 bzw. p2 und dieselbe n-leitende Schicht n1 bzw. n2 wie in der Tandemzelle nach Figur 1 vorhanden ist.

Es ist jedoch auch möglich, ohne die Genauigkeit der Bestimmung der Kenngrößen der Mehrfachsolarzelle, insbesondere deren Leistung, wesentlich zu beeinflussen, die p-leitende Schicht p1 und die n-leitende Schicht n1 in der top-Zelle 1 der Referenzzelle Rb und die p-leitende Schicht p2 und die n-leitende Schicht n2 der Referenzzellen Rt, falls die intrinsische Schicht in eine elektrisch leitende Schicht 11 bzw. 12 umgewandelt worden ist, wegzulassen. Die Schicht 11 und 12 weist jedoch dann die gleiche Schichtdicke auf wie die Teilzelle 1 bzw. 2 der Tandemzelle nach Figur 1. D. h. die gesamte Halbleiterschicht, aus der die Teilzelle 1 bzw. 2 der Referenzzelle Rb bzw. Rt besteht, ist zur elektrisch leitfähigen Schicht 11, 12 dotiert worden. Die leitfähige Schicht 11 und 12 besitzt also die gleiche Schichtdicke wie die Teilzelle 1 bzw. 2 der Tandemzelle nach Figur 1.

## Patentansprüche

1. Verfahren zur Bestimmung der Kenngrößen einer zu prüfenden photovoltaischen Einrichtung, welche wenigstens eine Mehrfachsolarzelle aufweist, die aus wenigstens zwei übereinander geschichteten, elektrisch und optisch in Serie geschalteten Teilzellen (1, 2) besteht, die jeweils eine p-leitende Schicht (p1, p2), eine intrinsische Schicht (i1, i2) und eine n-leitende Schicht (n1,n2) aufweisen,
wobei für jede Teilzelle (1, 2) der wenigstens zwei Teilzellen (1, 2) der wenigstens einen Mehrfachsolarzelle der zu prüfenden photovoltaischen Einrichtung eine Referenzzelle (Rb, Rt) hergestellt wird, welche zumindest zwei Teilzellen (1,2) umfasst, wobei die eine Teilzelle (2, 1) jeder Referenzzelle (Rb, Rt) einer Teilzelle (2, 1) der wenigstens zwei Teilzellen (1, 2) der wenigstens einen Mehrfachsolarzelle der zu prüfenden photovoltaischen Einrichtung entspricht, während die wenigstens eine weitere Teilzelle (1, 2) jeder Referenzzelle (Rb, Rt) wenigstens eine Schicht (11, 12) aufweist, welche der intrinsischen Schicht (i1, i2) der wenigstens einen weiteren Teilzelle (1, 2) der wenigstens einen Mehrfachsolarzelle der zu prüfenden photovoltaischen Einrichtung entspricht, jedoch durch Dotierung in eine elektrisch leitfähige Schicht (11, 12) umgewandelt ist,
die spektrale Empfindlichkeit der Referenzzellen (Rb, Rt) gemessen wird, und
zur Bestimmung der Kenngrößen der wenigstens einen Mehrfachsolarzelle die Kenngrößen der Referenzzellen (Rb, Rt) und die Kenngrößen der wenigstens einen Mehrfachsolarzelle mit einem auf die Referenzzellen (Rb und Rt) kalibrierten Sonnensimulator unter den gleichen Bedingungen gemessen werden.

2. Verfahren nach Anspruch 1, **dadurch gekennzeichnet, dass** die wenigstens eine weitere Teilzelle (1, 2) der Referenzzelle (Rb, Rt) die durch Dotierung der intrinsischen Schicht (i1, i2) in eine elektrisch leitfähige Schicht (11, 12) umgewandelte Schicht sowie die p-leitende Schicht (p1, p2) und/oder n-leitende Schicht (n1, n2) der wenigstens einen weiteren Teilzelle (1,2) der wenigstens einen Mehrfachsolarzelle der zu prüfenden photovoltaischen Einrichtung aufweist.

3. Verfahren nach Anspruch 1 oder 2, **dadurch gekennzeichnet, dass** die Kenngrößen einer Silizium-Mehrfachsolarzelle bestimmt werden.

4. Verfahren nach Anspruch 3, **dadurch gekennzeichnet, dass** die intrinsische Schicht (i1, i2) der Silizium-Mehrfachsolarzelle aus Siliziummaterial mit der gleichen oder unterschiedlichen Bandlücken aufgebaut ist.

5. Verfahren nach einem der vorstehenden Ansprüche,
**dadurch gekennzeichnet, dass** die Dunkelleitfähigkeit der durch Dotierung in eine elektrisch leitfähige Schicht (11, 12) umgewandelten intrinsischen Schicht (i1, i2) mindestens 10E-5 S/cm beträgt.

6. Verfahren nach einem der vorstehenden Ansprüche,
**dadurch gekennzeichnet, dass** ein Sonnensimulator verwendet wird, der ein Strahlungsspektrum aufweist, das von dem Referenzsonnenspektrum abweicht.

7. Verfahren nach einem der vorstehenden Ansprüche,
**dadurch gekennzeichnet, dass** die zur Ermittlung der Leistung der Referenzzellen und der wenigstens einen Mehrfachsolarzelle erforderlichen Kenngrößen bestimmt werden.

8. Verfahren nach Anspruch 1, **dadurch gekennzeichnet, dass** die photovoltaische Einrichtung durch ein photovoltaisches Modul mit mehreren Einzelzellen gebildet wird.

9. Referenzzelle zur Durchführung des Verfahrens nach einem der Ansprüche 1 bis 7, **dadurch gekennzeichnet, dass** sie wenigstens zwei Teilzellen (1, 2) umfasst, wobei die eine Teilzelle (2, 1) der Referenzzelle (Rb, Rt) einer Teilzelle (2, 1) der wenigstens zwei Teilzellen (1, 2) der wenigstens einen Mehrfachsolarzelle der zu prüfenden photovoltaischen Einrichtung entspricht, während die wenigstens eine weitere Teilzelle (1, 2) jeder Referenzzelle (Rb, Rt) wenigstens eine Schicht (11, 12) aufweist, welche der intrinsischen Schicht (i1, i2) der wenigstens einen weiteren Teilzelle (1, 2) der wenigstens einen Mehrfachsolarzelle der zu prüfenden photovoltaischen Einrichtung entspricht, jedoch durch Dotierung in eine elektrisch leitfähige Schicht (11, 12) umgewandelt ist.

10. Referenzzelle nach Anspruch 9, **dadurch gekennzeichnet, dass** die wenigstens eine weitere Teilzelle (2, 1) der Referenzzelle (Rb, Rt) einer Teilzelle (2, 1) der wenigstens zwei Teilzellen (1, 2) der wenigstens einen Mehrfachsolarzelle der zu prüfenden photovoltaischen Einrichtung entspricht und die zumindest eine elektrisch leitfähige Schicht (11, 12) der einen der wenigstens zwei Teilzellen (2, 1) der Referenzzelle (Rb, Rt) der intrinsischen Schicht **(i1,** i2) der wenigstens einen weiteren Teilzelle (1, 2) der einen Mehrfachsolarzelle der zu prüfenden photovoltaischen Einrichtung entspricht, jedoch durch Dotierung zur elektrisch leitfähigen Schicht (11, 12) umgewandelt ist.

11. Referenzzelle nach Anspruch 9, **dadurch gekennzeichnet, dass** die wenigstens eine weitere Teilzelle (1,2) der Referenzzelle (Rb, Rt) die durch Dotierung der intrinsischen Schicht (i1, i2) in eine elektrisch leitfähige Schicht (11, 12) umgewandelte Schicht sowie die p-leitende Schicht (p1, p2) und/oder n-leitende Schicht (n1, n2) der wenigstens einen weiteren Teilzelle (1,2) der Mehrfachsolarzelle aufweist.

12. Referenzmodul zur Durchführung des Verfahrens nach Anspruch 8, **dadurch gekennzeichnet, dass** es mehrere Einzelzellen aufweist, die jeweils aus einer Mehrfachsolarzelle aus wenigstens zwei übereinander geschichteten elektrisch und optisch in Serie geschalteten Teilzellen bestehen, wobei jede Einzelzelle wenigstens zwei Teilzellen umfasst, wobei eine der wenigstens zwei Teilzellen zumindest eine elektrisch leitfähige Schicht (11, 12) aufweist.

13. Referenzmodul zur Durchführung des Verfahrens nach Anspruch 8, **dadurch gekennzeichnet, dass** eine Teilzelle jeder Einzelzelle einer Teilzelle der wenigstens zwei Teilzellen der Mehrfachsolarzelle der zu prüfenden photovoltaischen Einrichtung entspricht, während die wenigstens eine weitere Teilzelle der Einzelzelle zumindest eine Schicht aufweist, welche der intrinsischen Schicht der wenigstens einen weiteren Teilzelle der einen Mehrfachsolarzelle der zu prüfenden photovoltaischen Einrichtung entspricht, jedoch durch Dotierung in eine elektrisch leitfähige Schicht umgewandelt ist.

14. Referenzmodul nach Anspruch 13, **dadurch gekennzeichnet, dass** die wenigstens eine weitere Teilzelle der Einzelzellen der Mehrfachsolarzellen die durch Dotierung der intrinsischen Schicht in eine elektrisch leitfähige Schicht umgewandelte Schicht sowie die p-leitende Schicht und/oder n-leitende Schicht der wenigstens einen weiteren Teilzelle der Einzelzellen der Mehrfachsolarzellen aufweist.
